# EUROPEAN PATENT APPLICATION

(11) **EP 0 744 774 A2**
(43) Date of publication of application: **27.11.1996**
(21) Application number: 96108283.1
(22) Date of filing: 23.05.1996
(51) Int. Cl.: H01L 29/417

(54) **Field effect transistor and method for producing same**

(30) Priority: 25.05.1995 JP 126385/95
(71) Applicant: MURATA MANUFACTURING CO., LTD., Nagaokakyo-shi Kyoto-fu 226 (JP)
(72) Inventor: Takashi, Murakawa, Murata Manufacturing Co., Ltd., Nagaokakyo-shi, Kyoto-fu (JP); Hiroyuki, Nakano, Murata Manufacturing Co., Ltd., Nagaokakyo-shi, Kyoto-fu (JP)
(74) Representative: Gossel, Hans K., Dipl.-Ing.

(57) **Abstract**

A field effect transistor includes: a semiconductor substrate; an active layer formed on a part of a principal surface of the semiconductor substrate and having a predetermined impurity concentration; and first and second heavily doped layers having an impurity concentration higher than the impurity concentration of the active layer formed in two respective areas of the principal surface of the semiconductor substrate, located on both sides of the active layer and in contact with the active layer. A gate electrode is formed on a surface of the active layer and a drain electrode and a source electrode are formed on respective surfaces of the first and second heavily doped layers. At least one of the drain electrode and the source electrode is formed so as to extend onto a surface of the active layer.

## Description

### BACKGROUND OF THE INVENTION

The present invention relates to a field effect transistor and a method of manufacturing the same, and more particularly to a compound semiconductor field effect transistor for use as a high frequency device or a high power device and a method for producing the same.

In general, the mobility of electrons in a low electrical field is higher in a compound semiconductor than in Si. This means that the speed of electrons moving in a compound semiconductor can be higher than in Si. Therefore, a compound semiconductor is suitable for microwave and millimeter-wave devices and high power devices. Especially, field effect transistors having a Schottky junction gate utilizing gallium arsenide (GaAs), which is a typical material for compound semiconductors (hereinafter referred to as a "GaAs MESFET"), are under active research and development for realizing a low noise, high power device for use as a microwave device.

A GaAs MESFET is generally configured by forming a gate electrode in Schottky contact with an active layer formed on the upper surface of a semi-insulating GaAs substrate and by forming a source electrode and a drain electrode in ohmic contact with the active layer on both sides of the gate electrode. However, a surface depletion layer is generated by surface charge on the surface of the GaAs substrate, which above-described configuration is unable to provide excellent increases parasitic resistance and reduces both mutual conductance gₘ in high frequency bands and a current gain cut-off frequency f_{T}. Therefore, a GaAs MESFET having the high frequency characteristics and is limited in applicability to high power use.

In order to avoid the influence of a surface depletion layer, there has been conceived a recessed gate structure in which a recess is formed in a active layer and a gate electrode is formed on the bottom of the recess. In a recessed gate structure, the recess improves high frequency characteristics, and the breakdown voltage can be increased by preventing an electrical field from concentrating at an edge of the gate electrode. Moreover, a heavily doped layer having a high impurity concentration is formed at the areas where the drain and source electrodes are to be formed in order to reduce the ohmic contact resistance between the drain and source electrodes and the active layer.

Further, in order to improve the breakdown characteristics such as the gate breakdown voltage, there has been conceived an offset gate structure in which a distance between the gate electrode and the drain electrode is greater than that between the gate electrode and source electrode to prevent an electric field from concentrating at an edge of the gate electrode on the side toward the drain electrode. There has also been conceived a step recess structure in which a recess is formed at the bottom of another recess to formed stepped side faces.

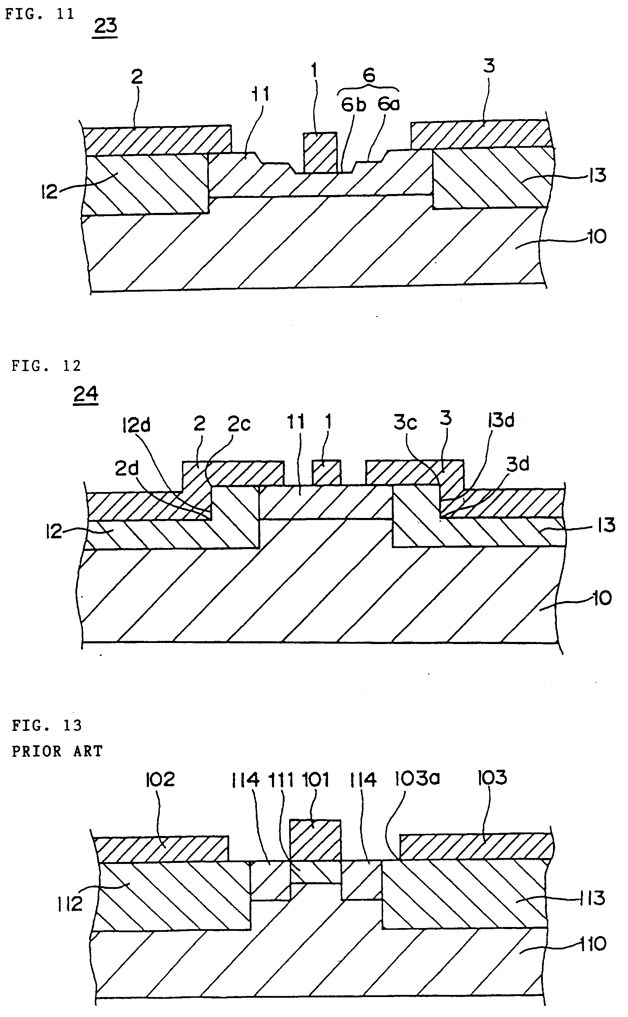

In addition, an LDD (Lightly Doped Drain) structure as shown in Fig. 13 has recently been proposed. The field effect transistor having the LDD structure shown in Fig. 13 is configured by forming a source electrode 102, a drain electrode 103, and a gate electrode 101 on the upper surface of a GaAs substrate 110 having an active layer 111, heavily doped layers 112 and 113, and a moderately (medium) doped layer 114. In the field effect transistor having the LDD structure shown in Fig. 13, the impurity concentration of the moderately doped layer 114 is set to a value in the range between the impurity concentrations of the active layer 111 and the heavily doped layers 112 and 113. According to the structure, the gate breakdown voltage is increased by relieving a electrical field at the edge of the gate electrode 101 on the side toward the drain electrode 103.

However, the above-described offset gate structure has a problem in that the great distance between the gate and drain electrodes increases parasitic resistance between the gate and drain electrodes, thereby deteriorating high frequency characteristics. Further, although the offset gate structure, step recess structure, and LDD structure can improve the gate breakdown voltage by relieving an electrical field at the edge of the gate electrode, drain breakdown voltage cannot be improved. This has resulted in a problem in that an FET having such a structure is difficult to use at high power.

In order to obtain a sufficient drain breakdown voltage, given these considerations, the distance between the gate and drain electrodes must be large as in an offset gate structure, and this increases parasitic resistance. This has also resulted in a problem, in that the mutual conductance gₘ in high frequency bands and current gain cut-off frequency f_{T} cannot be increased. Furthermore, the above-described step recess structure and LDD structure have had a problem, in that they involve complicated manufacturing processes which make control over processing conditions difficult and in that a GaAs MESFET having the above-described step recess structure and a GaAs MESFET having the LDD structure are not reliable enough.

### SUMMARY OF THE INVENTION

It is therefore an object of the preferred embodiments of present invention to provide a field effect transistor and a method of manufacturing the same in which the above-described problems are solved and in which the mutual inductance gₘ in high frequency bands and the current gain cut-off frequency f_{T} can be high.

According to a preferred embodiment of the invention, a field effect transistor includes: a semiconductor substrate; an active layer formed on a part of a principal surface of the semiconductor substrate and having a predetermined impurity concentration; first and second heavily doped layers having an impurity concentration higher than the impurity concentration of the active layer formed in two respective areas of the principal surface of the semiconductor substrate located on both sides of the active layer in contact with the active layer; a gate electrode formed on a surface of the active layer; a drain electrode formed on a surface of the first heavily doped layer; and a source electrode formed on the surface of the second heavily doped layer, wherein at least one of the drain electrode and the source electrode is formed so as to extend onto a surface of the active layer.

According to another preferred embodiment of the present invention, a field effect transistor includes: a semiconductor substrate; an active layer formed on a part of a principal surface of the semiconductor substrate and having a predetermined impurity concentration; first and second heavily doped layers having an impurity concentration higher than the impurity concentration of the active layer formed in two respective areas of the principal surface of the semiconductor substrate and located on both sides of the active layer at predetermined intervals from the active layer; medium doped layers having an impurity concentration higher than the impurity concentration of the active layer and lower than the impurity concentration of the heavily doped layers formed in a region between the active layer and the first heavily doped layer and a region between the active layer and the second heavily doped layer; a gate electrode formed on a surface of the active layer; a drain electrode formed on the surface of the first heavily doped layer; and a source electrode formed on a surface of the second heavily doped layer, wherein at least one of the drain electrode and said source electrode is formed so as to extend onto a surface of said medium doped layer.

In a further embodiment, both of said drain electrode and said source electrode are formed so as to extend onto a surface of the medium doped layer or the active layer.

In another embodiment, a recess is formed by removing said active layer from the surface thereof to a predetermined depth, and the gate electrode is formed on the bottom of the recess.

In yet another embodiment, a step portion is formed in at least one of said first and second heavily doped layers, and the drain electrode or source electrode is formed on said step portion.

According to still another aspect of the invention, a method of manufacturing a field effect transistor includes the steps of: forming an active layer having a predetermined impurity density on a part of a principal surface of a semiconductor substrate; forming first and second heavily doped layers having an impurity density higher than the impurity density of the active layer in two respective areas of the principal surface of the semiconductor substrate located on both sides of the active layer and in contact with the active layer; forming a resist film on the principal surface of the semiconductor substrate so as to expose a drain electrode formation region including a surface of the first heavily doped layer and a source electrode formation region including a surface of the second heavily doped layer, at least one of the drain electrode formation region and the source electrode formation region also including a part of the surface of the active layer including either the part in contact with the first heavily doped layer or the second heavily doped layer; forming a drain electrode in the drain electrode formation region and forming a source electrode in the source electrode formation region; removing the resist film; and forming a gate electrode on the surface of the active layer located between the drain electrode and the source electrode at a predetermined interval from each of the drain electrode and the source electrode.

According to the field effect transistor of the preferred embodiments, the source electrode or the drain electrode provided on the heavily doped layer is in contact with the active layer or the medium doped layer at the end portion thereof. Therefore, a voltage drop of the voltage across the gate electrode and either the source electrode or the drain electrode is greater at the end portion than at the other portion of the electrode. As a result, an electrical field in the active layer in the vicinity of the end portion is relieved, and the drain breakdown voltage or source breakdown voltage can be improved. Further, since the source-gate distance and the drain-gate distance can be reduced, the gate-drain parasitic resistance and the gate-source parasitic resistance can be reduced. As a result, the mutual conductance gₘ in high frequency bands can be increased and a current gain cut-off frequency f_{T} can be made higher. The maximum output can be also increased.

For the purpose of illustrating the invention, there are shown in the drawings several forms which are presently preferred, it being understood, however, that the invention is not limited to the precise arrangements and instrumentalities shown. Other features and advantages or the present invention will become apparent from the following description.

### BRIEF DESCRIPTION OF THE DRAWINGS

Fig. 1 is a sectional view of a field effect transistor of a first embodiment of the present invention.

Fig. 2 is a sectional view of a semiconductor substrate 10 on the upper surface of which an n-type semiconductor layer 31 is formed in a step of manufacturing the field effect transistor of the embodiment shown in Fig. 1.

Fig. 3 is a sectional view of the semiconductor substrate 10 on which heavily doped layers 12 and 13 are formed in a step of manufacturing the field effect transistor of the embodiment shown in Fig. 1.

Fig. 4 is a sectional view of the semiconductor substrate 10 on which a resist film 46 is formed in a step of manufacturing the field effect transistor of the embodiment shown in Fig. 1.

Fig. 5 is a sectional view of the semiconductor substrate 10 on which a source electrode and a drain electrode are formed in a step of manufacturing the field effect transistor of the embodiment shown in Fig. 1.

Fig. 6 is a sectional view of the semiconductor substrate 10 on which a resist film 47 is formed in a step of manufacturing the field effect transistor of the embodiment shown in Fig. 1.

Fig. 7 is a sectional view of the semiconductor substrate 10 on which an electrode 1 is formed in a step of manufacturing the field effect transistor of the embodiment shown in Fig. 1.

Fig. 8 is a sectional view of a field effect transistor 22 of a second embodiment of the present invention.

Fig. 9 is a sectional view of the semiconductor substrate 10 on which ion implantation is carried out after forming a SiO₂ film 48 in a step of manufacturing the field effect transistor 22 of the second embodiment.

Fig. 10 is a sectional view of the semiconductor substrate 10 on which ion implantation is carried out after forming side walls 49a and 49b on the sides of the SiO₂ film 48 in a step of manufacturing the field effect transistor 22 of the second embodiment.

Fig. 11 is a sectional view of a field effect transistor 23 of a third embodiment of the present invention.

Fig. 12 is a sectional view of a field effect transistor 24 of a fourth embodiment of the present invention.

Fig. 13 is a sectional view of a conventional field effect transistor.

### DETAILED DESCRIPTION OF PREFERRED EMBODIMENTS OF THE INVENTION

Hereinafter, preferred embodiments of the present invention are explained in detail with reference to the drawings.

### (First Embodiment)

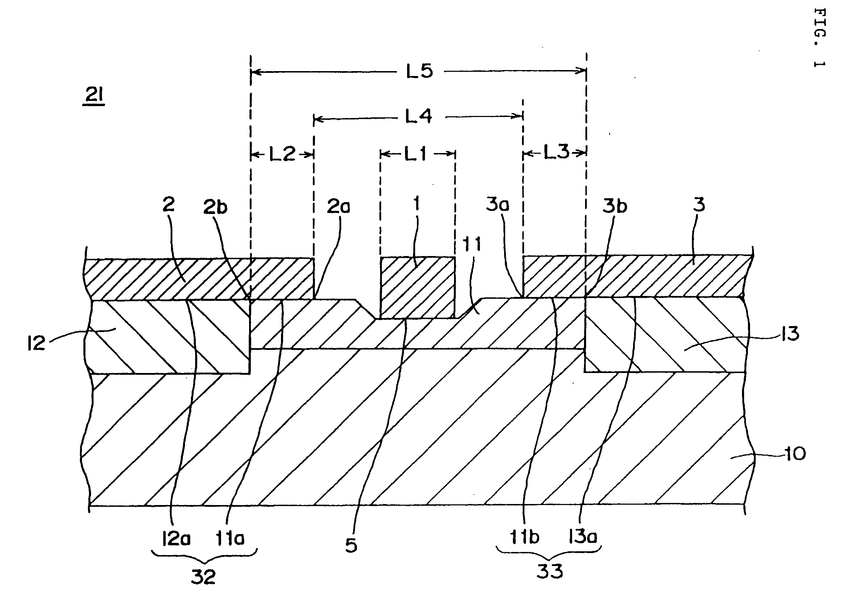

Fig. 1 is a sectional view of a field effect transistor 21 according to a first embodiment of the present invention. The field effect transistor 21 is a gallium arsenide MESFET and includes a semiconductor substrate 10. An active layer 11 is provided on the semiconductor substrate 10 and heavily doped layers 12 and 13 are provided on the semiconductor substrate 10 on respective sides of the active layer 11. A recess 5 is provided in the active layer 11 and a gate electrode 1 is provided on the bottom of the recess 5.

A source electrode 2 is provided on a surface 12a of the heavily doped layer 12 and a surface 11a of the active layer 11, while a drain electrode 3 is provided on a surface 13a of the heavily doped layer 13 and a surface 11b of the active layer 11. That is, the source electrode 2 is provided so as to extend from the surface 12a of the heavily doped layer 12 to the surface 11a of the active layer 11, and the drain electrode 3 is formed so as to extend from the surface 13a of the heavily doped layer 13 to the surface 11b of the active layer 11. As a result, the edges of the source electrode 2 and the drain electrode 3 are offset toward the gate electrode with respect to the edge of the heavily doped layers 12 and 13, respectively.

The configuration of the field effect transistor of the first embodiment will now be described in more detail with reference to Fig. 1. In Fig. 1, the semiconductor substrate 10 is constituted by GaAs single crystal produced using the liquid encapsulation Czochralski method. The active later 11 is an n-type semiconductor layer having a predetermined width L5 and a predetermined length in a gate length direction and having a predetermined impurity concentration, provided on the semiconductor substrate 10. Further, a groove-shaped recess 5 having a predetermined width, a predetermined length, and a predetermined depth extending along the gate width direction is provided in the middle of the surface of the active layer 11.

The heavily doped layers 12 and 13 are formed on the upper surface of the semiconductor substrate 10 on both sides of the active layer 11 so as to be in contact with the active layer 11. The heavily doped layers 12 and 13 have an impurity concentration higher than the impurity concentration of the active layer 11.

The gate electrode 1 is formed on the bottom of the recess 5 along the extending direction of the recess 5 and is in Schottky contact with the active layer 11. The source electrode 2 and the drain electrode 3 are formed on both sides of the gate electrode 1 at predetermined intervals from the gate electrode 1.

The source electrode 2 is formed on the surface 12a of the heavily doped layer 12 and the surface 11a of the active layer 11, and this forms ohmic contact between the source electrode 2 and the heavily doped layer 12 and ohmic contact between the source electrode 2 and the active layer 11. The surface 11a of the active layer 11 is a portion having a predetermined width L2 along the surface of the active layer 11 which extends along the boundary between the active layer 11 and the heavily doped layer 12. The drain electrode 3 is formed on the surface 13a of the heavily doped layer 13 and the surface 11b of the active layer 11, and this forms ohmic contact between the drain electrode 3 and the heavily doped layer 13 and ohmic contact between the drain electrode 3 and the active layer 11. The surface 11b of the active layer 11 is a portion having a predetermined width L3 along the surface of the active layer 11 which extends along the boundary between the active layer 11 and the heavily doped layer 13.

Since the heavily doped layer 12 has an impurity concentration higher than that of the active layer 11, contact resistance between the heavily doped layer 12 and the source electrode 2 at the surface 12a of the heavily doped layer 12 is lower than contact resistance between the active layer 11 and the source electrode 2 at the surface 11a of the active layer 11. Similarly, since the heavily doped layer 13 has an impurity concentration higher than that of the active layer 11, contact resistance between the heavily doped layer 13 and the drain electrode 3 at the surface 13a of the heavily doped layer 13 is lower than contact resistance between the active layer 11 and the drain electrode 3 at the surface 11b of the active layer 11. The field effect transistor 21 of the first embodiment is configured as described above.

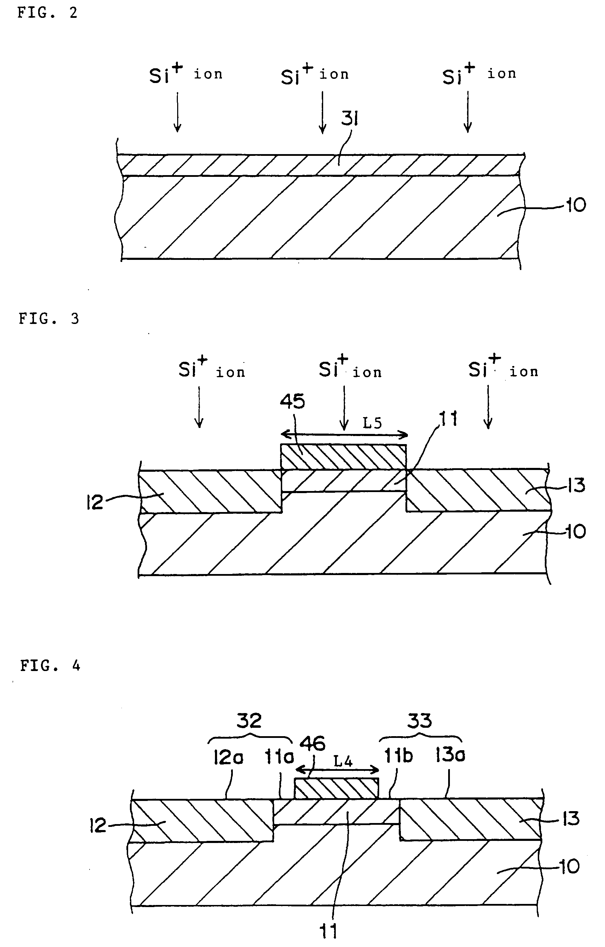

A method of manufacturing the field effect transistor 21 will now be described. Figs. 2 through 7 are sectional views of the semiconductor substrate 10 after major steps of the manufacturing method. The method of manufacturing the field effect transistor 21 will now be described with reference to the drawings.

According to the method of manufacturing the field effect transistor 21 of the first embodiment, as shown in Fig. 2, an n-type semiconductor layer 31 is first formed on the upper surface of a semiconductor substrate 10 by implanting impurities which are Si⁺ ions using an ion implantation process under a condition of 80 KeV, 6 X 10¹²/cm².

Next, as shown in Fig. 3, a photo resist 45 mainly composed of novolac type resin, cyclized rubber type resin or the like is formed in the middle of the semiconductor substrate 10. The photo resist 45 extends along a direction which to be a gate width direction and has a width of L5 and a predetermined length. Impurities ions such as Si⁺ ions are implanted using the photo resist 45 as a mask by an ion implantation process from above the semiconductor substrate 10 under conditions of 120 KeV, 2 X 10¹³/cm² . As a result, an active layer 11 having an impurity concentration equal to the impurity concentration of the n-type semiconductor layer 31 is remained directly under the photo resist 45, and heavily doped layers 12 and 13 having an impurity concentration higher than the impurity concentration of the n-type semiconductor layer 31 are formed on both sides of the active layer 11.

Next, as shown in Fig. 4, after removing the photo resist 45, a photo resist 46 extending along the gate width direction is formed in the middle of the surface of the active layer 11. The photo resist 46 has a width of L4 which is smaller than the width of L5. The photo resist 46 is formed on the surface of the active layer 11 so that a source electrode formation region 32 including a surface 12a of a heavily doped layer 12 and a surface 11a of the active layer 11 and a drain electrode formation region 33 including a surface 13a of a heavily doped region 13 and a surface 11b of the active layer 11 are exposed.

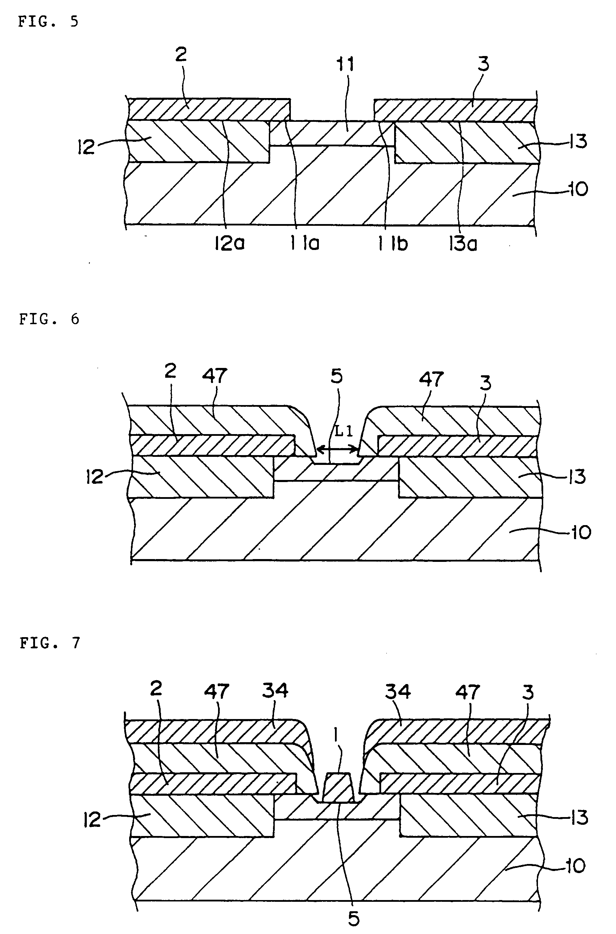

Then, Au-Ge/Ni type electrodes are formed using a vacuum deposition process from above the semiconductor substrate 10. After removing the photo resist 46 by a lift-off method, the Au-Ge/Ni type electrodes are alloyed by performing heat treatment at a temperature of 380°C to form a source electrode 2 in ohmic contact with the heavily doped layer 12 and the active layer 11 and a drain electrode 3 in ohmic contact with the heavily doped layer 13 and the active layer 11. Thus, as shown in Fig. 5, the source electrode 2 is formed on the surface 12a of the heavily doped layer 12 so as to extend onto the surface 11a of the active layer 11, and the drain electrode 3 is formed on the surface 13a of the heavily doped layer 13 so as to extend onto the surface 11b of the active layer 11.

Further, as shown in Fig. 6, a photo resist 47 covering the surfaces of the source electrode 2 and the drain electrode 3 is formed so that it extends onto the surface of the active layer 11 to a predetermined distance from the end face of the source electrode 2 and in a predetermined distance from the end face of the drain electrode 3. As a result, a surface having a width of L1 in the middle of the active layer 11 is exposed at the predetermined distances from the source electrode 2 and the drain electrode 3. Then, a part of the active layer 11 is removed using a wet etching process to a predetermined depth from the exposed surface of the active layer 11 to form a recess 5. A phosphoric acid type aqueous solution is used as the etchant for removing the active layer 11. After the recess 5 is formed, as shown in Fig. 7, an aluminum film is deposited using a vacuum deposition process from above the semiconductor substrate 10 so as to form a film 34 on the photo resist 47 and form a film in the recess 5 as a gate electrode 1. Next, the film 34 and the photo resist 47 are removed by a lift-off method. The field effect transistor 21 of the first embodiment is manufactured through the above-described steps.

In the field effect transistor 21 configured as described above, when a voltage is applied between the drain electrode 3 and the source electrode 2, a source-drain current flows from the drain electrode 3 to the source electrode 2 through the active layer 11 under the gate electrode 1. When a signal voltage is applied to the gate electrode 1 in this state, the thickness of a depletion layer formed in the active layer 11 and located directly under the gate electrode 1 changes in accordance with changes in the amplitude of the voltage of the voltage signal. This results in changes in the source-drain current. Thus, the field effect transistor 21 performs an amplifying operation.

Hereinafter, referring to Fig. 1, the distribution of electrical fields in the active layer 11 and the heavily doped layer 13 during the operation of the field effect transistor 21 will be explained. As described above, the contact resistance between the drain electrode 3 and the active layer 11 is higher than the contact resistance between the drain electrode 3 and the heavily doped layer 13. Therefore, a voltage drop of a voltage Vgd (i.e., a voltage between the gate electrode 1 and the drain electrode 3 during the operation of the field effect transistor 21) caused by the contact resistance between the drain electrode 3 and the active layer 11 is greater than a voltage drop of the voltage Vgd caused by the contact resistance between the drain electrode 3 and the heavily doped layer 13. As a result, compared to an electrical field in a heavily doped layer 113 (Fig. 13) in the vicinity of an electrode edge portion 103a according to the prior art, the concentration of an electrical field in the active layer 11 in the vicinity of an electrode edge portion 3a is relieved in accordance with the amount by which the voltage drop of the voltage Vgd caused by the contact resistance between the drain electrode 3 and the active layer 11 is greater than the voltage drop of the voltage Vgd caused by the contact resistance between the drain electrode 3 and the heavily doped layer 13. This makes it possible to increase the drain breakdown voltage compared to the prior art. In the field effect transistor 21 of the first embodiment, the distribution of the electrical field in the active layer 11 in the vicinity of the lower side of the drain electrode 3 is concentrated in two locations, i.e., the electrode edge portion 3a and a boundary portion 3b. In other words, in the first embodiment, the high electrical field in the heavily doped layer 113 in the vicinity of the electrode edge portion 103 of the prior art is delocalized to be in those two locations, i.e., the electrode edge portion 3a and the boundary portion 3b.

Further, in the field effect transistor 21 of the first embodiment, the source electrode 2 is formed on the surface 12a of the heavily doped layer 12 so as to extend to the surface 11a of the active layer 11. As a result, the source breakdown voltage can be also improved for the same reason the drain breakdown voltage is improved as described above.

In addition, the recess 5 reduces the influence of a surface depletion layer, prevents parasitic resistance between the gate and source and between the gate and drain from being increased, and relieves a high electrical field in the active layer 11 in the vicinity of an edge of the gate electrode, thereby improving the gate breakdown voltage.

In order to confirm the above-described effects, the inventors fabricated a field effect transistor 21 according to the first embodiment and a field effect transistor as an example for comparison based on the structural parameters shown on Table 1 and measured the drain breakdown voltage of each of them. Table 2 shows the result. A selective implantation type planar MESFET was used as the field effect transistor for comparison. The "S-D distance" in Table 1 means the distance between the source electrode and drain electrode.

**Table 1**

| | First embodiment | Conventional art |
|---|---|---|
| Gate length L1 | 0.5 µm | 0.5 µm |
| Gate width | 100 µm | 100 µm |
| Distance L5 | 4.5 µm | 4.5 µm |
| S-D distance L4 | 2.5 µm | 6.5 µm |

**Table 2**

| | Drain breakdown voltage |
|---|---|
| Field effect transistor 21 of the first embodiment | 30 V |
| Field effect transistor of the conventional art | 18 V |

As apparent from Table 1 and Table 2, the drain breakdown voltage of the field effect transistor 21 of the first embodiment can be greater than that of the comparative example of the field effect transistor despite the fact that a small S-D distance L4 is set.

As described above in detail, in the field effect transistor 21 of the first embodiment, the source electrode and the drain electrode 3 are formed so as to extend from the surfaces 12a and 13a of the heavily doped layers 12 and 13 onto the surfaces 11a and 11b of the active layer 11, respectively. In other words, the source-drain electrode distance L4 is less than the distance L5 between the heavily doped layers 12 and 13. As a result, a high electrical field in the vicinity of electrode edge portions 2a and 3a can be relieved to make the source and drain breakdown voltages higher than in the prior art. This allows the field effect transistor 21 to output a signal of high power.

Further, this structure can achieve reduction of the distance between the gate electrode 1 and the drain electrode 3 and the distance between the gate electrode 1 and the source electrode 2, as well as increasing the source and drain breakdown voltages. Therefore, it is possible to reduce parasitic resistance between the gate and source and between the gate and drain. As a result, compared to the prior art, this transistor can have greater mutual conductance gₘ in high frequency bands and a higher current gain cut-off frequency f_{T} and can operate at a low voltage. Further, the reduction of parasitic resistance between the gate and source and between the gate and drain allows the maximum current and therefore the maximum output to be increased.

### (Second Embodiment)

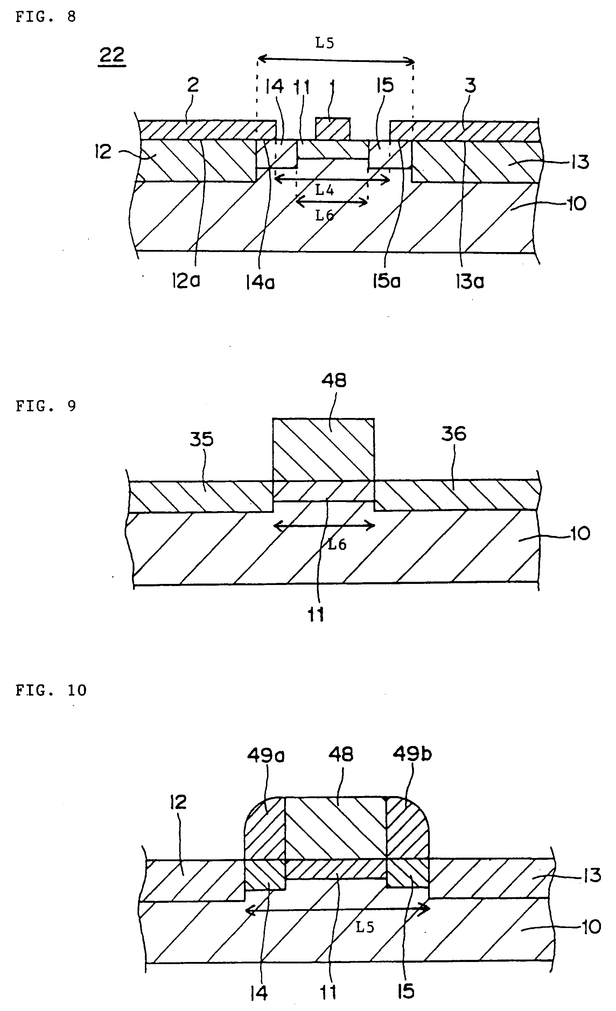

Fig. 8 is a sectional view of a field effect transistor 22 of a second embodiment of the present invention. In Fig. 8, the same components as those in the field effect transistor 21 in Fig. 1 are indicated by the same reference numbers. The field effect transistor 22 of the second embodiment shown in Fig. 8 is different from the field effect transistor 21 of the first embodiment shown in Fig. 1 on the following points.

A medium doped layer 14 is provided between the heavily doped layer 12 and the active layer 11, and a medium doped layer 15 is provided between the heavily doped layer 13 and the active layer 11. The source electrode 2 is formed on the surface 12a of the heavily doped layer 12 so as to extend onto a surface 14a which is a part of the surface of the medium doped layer 14. The source electrode 2 is in ohmic contact with the heavily doped layer 12 and the medium doped layer 14. The drain electrode 3 is formed on the surface 13a of the heavily doped layer 13 so as to extend onto a surface 15a which is a part of the surface of the medium doped layer 15. The drain electrode 2 is in ohmic contact with the heavily doped layer 13 and the medium doped layer 15. The recess 5 in the field effect transistor 21 of the first embodiment is not formed in the field effect transistor 22 of the second embodiment.

The medium doped layers 14 and 15 are formed as follows. As shown in Fig. 2, an n-type semiconductor layer 31 is first formed on a semiconductor substrate 10 just as in the method of manufacturing the field effect transistor 21 of the first embodiment. Next, as shown in Fig. 9, a SiO₂ film 48 extending a direction which to be a gate width direction is formed in the middle of the semiconductor substrate 10. The SiO₂ film 48 has a width L6. Impurities ions such as Si⁺ ions are implanted using an ion implantation process from above the semiconductor substrate 10. As a result, n-type semiconductor layers 35 and 36 having an impurity concentration higher than the impurity concentration of the n-type semiconductor layer 31 are formed on both sides of the SiO₂ film 48. Note that the impurity concentration of the n-type semiconductor layers 35 and 36 should be set to that of the medium doped layers 14 and 15. Then, as shown in Fig. 10, side walls 49a and 49b are formed on both sides of the SiO₂ film 48 so that a layer including the SiO₂ film 48 and the side walls 49a and 49b has a width L5. Further, impurities ions such as Si⁺ ions are implanted using the layer as a mask by an ion implantation process from above the semiconductor substrate 10. The SiO₂ film 48 and the side walls 49a and 49b are removed. Thus, the active layer 11, medium doped layers 14 and 15, and the heavily doped layers 12 and 13 are formed.

The field effect transistor 22 of the second embodiment configured as described above performs the same operation as that of the field effect transistor 21 of the first embodiment and provides the same effects. Further, the gate breakdown voltage of the field effect transistor of the second embodiment can be improved just as in the field effect transistor of the first embodiment because it includes the medium doped layers 14 and 15 instead of the recess 5.

### (Third embodiment)

Fig. 11 is a sectional view of a field effect transistor 23 of a third embodiment of the present invention. In Fig. 11, the same components as those in the field effect transistor 21 in Fig. 1 are indicated by the same reference numbers. The field effect transistor 23 of the third embodiment shown in Fig. 11 is different from the field effect transistor 21 of the first embodiment shown in Fig. 1 in that the field effect transistor 23 is provided with a step recess 6 instead of the recess 5 shown in Fig. 1. The step recess 6 is configured by forming a recess 6b at the bottom of the recess 6a. This configuration allows a high electrical field at an edge of the gate electrode 1 to be relieved to a greater degree compared to the first embodiment. This allows the gate breakdown voltage to be further improved compared to a case wherein the recess 5 is formed. That is, in the field effect transistor 23 shown in Fig. 9, the drain breakdown voltage can be improved just as in the first embodiment, and the gate breakdown voltage can be further improved compared to the first embodiment.

### (Fourth embodiment)

Fig. 12 is a sectional view of a field effect transistor 24 of a fourth embodiment of the present invention. In Fig. 12, the same components as those in the field effect transistor 21 in Fig. 1 are indicated by the same reference numbers. The field effect transistor 24 shown in Fig. 12 is different from the field effect transistor 21 of the first embodiment shown in Fig. 1 in the following points. A step portion 12d is formed in a surface of the heavily doped layer 12 at a predetermined interval from the active layer 11, and a step portion 13d is formed in a surface of the heavily doped layer 13 at a predetermined interval from the active layer 11. The source electrode 2 and the drain electrode 3 are formed on surfaces of the heavily doped layers 12 and 13 including the step portions 12d and 13d.

In the field effect transistor 24 configured as described above, when a predetermined voltage is applied to the gate electrode 1, source electrode 2, and drain electrode 3, each of the electrical fields in the active layer 11 and the heavily doped layers 12 and 13 is distributed to the step portion 12d including a step portion upper end 2c and a step portion lower end 2d and the step portion 13d including a step portion upper end 3c and a step portion lower end 3d. As a result, high electrical fields in the vicinity of the electrode edge portions 2a and 3a (Fig. 1) can be further relieved compared to those in the field effect transistor 21 of the first embodiment. That is, in the field effect transistor 24 of the fourth embodiment, the source breakdown voltage and the drain breakdown voltage can be further improved compared to those in the field effect transistor 21.

### (Other Modifications)

Although the configuration of the field effect transistor 21 of the above-described first embodiment includes a recess 5 formed therein, the present invention is not limited thereto and may be applied to a gallium arsenide MESFET having a planar structure without a recess. Such a configuration results in the same operation and effects as in the first embodiment.

Although each of the source electrode 2 and drain electrode 3 is extended onto the active layer 11 in the above-described first, third and fourth embodiments, the present invention is not limited thereto, and only one of the source electrode 2 and drain electrode 3 may be extended onto the active layer 11. This makes it possible to improve the source breakdown voltage or drain breakdown voltage.

Although the source electrode 2 and drain electrode 3 are extended onto the medium doped layers 14 and 15, respectively, in the above-described second embodiment, the present invention is not limited thereto, and only one of the source electrode 2 and drain electrode 3 may be extended onto the medium doped layer 14 or medium doped layer 15. Such a configuration also results in the same improvements as in the second embodiment and allows the source breakdown voltage or drain breakdown voltage to be improved.

Although no recess is formed in the above-described second embodiment, the present invention is not limited thereto, and a recess may be formed. Such a configuration also results in the same improvements and effects as in the second embodiment and allows the gate breakdown voltage to be improved compared to a case wherein no recess is formed.

Although no step portion is provided at the heavily doped layers 12 and 13 in the above-described second embodiment, the present invention is not limited thereto, and a step portion may be provided in at least one of the heavily doped layers 12 and 13. Such a configuration also results in the same improvements and effects as in the second embodiment and allows the source breakdown voltage or drain breakdown voltage to be further improved compared to a case wherein no step portion is provided.

According to the above-described method of manufacturing the field effect transistor 21 of the first embodiment, the photo resist 46 is formed so that the source electrode formation region 32 and the drain electrode formation region 33 include the surfaces 11a and 11b of the active layer 11, respectively. However, the present invention is not limited thereto, and the photo resist 46 may be formed so that only one of the source electrode formation region 32 or drain electrode formation region 33 includes the corresponding surface 11a or surface 11b. This also allows the source breakdown voltage or drain breakdown voltage to be improved.

Although the present invention has been described in relation to particular embodiments thereof, many other variations and modifications and other uses will become apparent to those skilled in the art. The present invention is not limited by the specific disclosure herein.

## Claims

1. A field effect transistor including:
a semiconductor substrate;
an active layer formed on a part of a principal surface of said semiconductor substrate and having a predetermined impurity concentration;
first and second heavily doped layers having an impurity concentration higher than the impurity concentration of said active layer, formed in two respective areas of the principal surface of said semiconductor substrate located on both sides of said active layer and in contact with said active layer;
a gate electrode formed on a surface of said active layer;
a drain electrode formed on a surface of said first heavily doped layer; and
a source electrode formed on the surface of said second heavily doped layer, wherein at least one of said drain electrode and said source electrode is formed so as to extend onto a respective surface of said active layer.

2. The field effect transistor according to Claim 1, wherein both of said drain electrode and said source electrode are formed so as to extend onto a respective surface of said active layer.

3. The field effect transistor according to Claim 1, wherein a recess is formed in said surface of said active layer to a predetermined depth and said gate electrode is formed on the bottom of said recess.

4. The field effect transistor according to Claim 3, wherein a portion of said recess is formed to a second predetermined depth which is less than said first-mentioned predetermined depth.

5. The field effect transistor according to Claim 1, wherein a step portion is formed in at least one of said first and second heavily doped layers and the corresponding said drain electrode or source electrode is formed on said step portion.

6. A field effect transistor including:
a semiconductor substrate; an active layer formed on a part of a principal surface of said semiconductor substrate and having a predetermined impurity density;
first and second heavily doped layers having an impurity concentration higher than the impurity concentration of said active layer, formed in two respective areas of the principal surface of said semiconductor substrate located on both sides of said active layer and at predetermined intervals from said active layer;
first and second medium doped layers having an impurity concentration higher than the impurity density of said active layer and lower than the impurity density of said heavily doped layers, formed respectively in a region between said active layer and said first heavily doped layer and a region between said active layer and said second heavily doped layer;
a gate electrode formed on a surface of said active layer;
a drain electrode formed on a surface of said first heavily doped layer; and
a source electrode formed on a surface of said second heavily doped layer, wherein at least one of said drain electrode and said source electrode is formed so as to extend onto a respective surface of a corresponding said medium doped layer.

7. The field effect transistor according to Claim 6, wherein both of said drain electrode and said source electrode are formed so as to extend onto a respective surface of a corresponding said medium doped layer.

8. The field effect transistor according to Claim 6, wherein a recess is formed in said surface of said active layer to a predetermined depth and said gate electrode is formed on the bottom of said recess.

9. The field effect transistor according to Claim 6, wherein a step portion is formed in a surface of at least one of said first and second heavily doped layers and the corresponding said drain electrode or source electrode is formed on said step portion.

10. A field effect transistor including:
a semiconductor substrate;
a central layer formed on a part of a principal surface of said semiconductor substrate and having a predetermined impurity concentration;
first and second heavily doped layers having an impurity concentration higher than the impurity concentration of said central layer, formed in two respective areas of the principal surface of said semiconductor substrate located on both sides of said central layer and in contact with said central layer;
a gate electrode formed on a surface of said central layer;
a drain electrode formed on a surface of said first heavily doped layer: and
a source electrode formed on the surface of said second heavily doped layer, wherein
at least one of said drain electrode and said source electrode is formed so as to extend onto a respective surface of said central layer.

11. The field effect transistor according to Claim 10, wherein said central layer is an active layer, said gate electrode being formed on said active layer, and said active layer being in contact with said first and second heavily doped layers.

12. The field effect transistor according to Claim 10, wherein said central layer includes an active layer, said gate electrode being formed on said active layer, and first and second medium doped layers interposed respectively between said active layer and said first and second heavily doped layers.

13. A method of manufacturing a field effect transistor, comprising the steps of:
forming an active layer having a predetermined impurity density on a part of a principal surface of a semiconductor substrate;
forming first and second heavily doped layers having an impurity density higher than the impurity density of said active layer in two respective areas of the principal surface of said semiconductor substrate located on both sides of said active layer and in contact with said active layer;
forming a resist film on the principal surface of said semiconductor substrate so as to expose a drain electrode formation region including a surface of said first heavily doped layer and a source electrode formation region including a surface of said second heavily doped layer, at least one of said drain electrode formation region and said source electrode formation region including a part of the surface of said active layer, including respectively either the part in contact with said first heavily doped layer or the part in contact with said second heavily doped layer;
forming a drain electrode in said drain electrode formation region and forming a source electrode in said source electrode formation region;
removing said resist film; and
forming a gate electrode on the surface of said active layer located between said drain electrode and said source electrode at a predetermined interval from each of said drain electrode and said source electrode.

14. A method of manufacturing a field effect transistor field effect transistor, comprising the steps of:
forming an active layer having a predetermined impurity density on a part of a principal surface of a semiconductor substrate;
forming first and second heavily doped layers having an impurity density higher than the impurity density of said active layer in two respective areas of the principal surface of said semiconductor substrate located on both sides of said active layer and at respective predetermined intervals from said active layer;
forming first and second medium doped layers having an impurity density higher than the impurity density of said active layer and lower than the impurity density of said heavily doped layers, in a region between said active layer and said first heavily doped layer and a region between said active layer and said second heavily doped layer, respectively, and being in contact with said first heavily doped layer and said second heavily doped layer, respectively;
forming a resist film on the principal surface of said semiconductor substrate so as to expose a drain electrode formation region including a surface of said first heavily doped layer and a source electrode formation region including a surface of said second heavily doped layer, at least one of said drain electrode formation region and said source electrode formation region including a part of the surface of said active layer, including respectively either the part in contact with said first heavily doped layer or the part in contact with said second heavily doped layer;
forming a drain electrode in said drain electrode formation region and forming a source electrode in said source electrode formation region;
removing said resist film; and forming a gate electrode on the surface of said active layer located between said drain electrode and said source electrode at a predetermined interval from each of said drain electrode and said source electrode.
